# EUROPÄISCHE PATENTSCHRIFT

(11) **EP 1 772 740 B1**
(45) Veröffentlichungstag und Bekanntmachung des Hinweises auf die Patenterteilung: **08.09.2010**
(21) Anmeldenummer: 06020351.0
(22) Anmeldetag: 28.09.2006
(51) Int. Cl.: G01R 33/34

(54) **Elektrisch symmetrische NMR-Spulen mit mehreren seriellen Windungen**
Electrically symmetric NMR coils with several serial windings
Bobines NMR symétriques électriques dotées de plusieurs enroulements de série

(30) Priorität: 06.10.2005 DE 102005047883
(43) Veröffentlichungstag der Anmeldung: 11.04.2007
(73) Patentinhaber: Bruker BioSpin AG, 8117 Fällanden (CH)
(72) Erfinder: Freytag, Nicolas, 8122 Binz (CH); Marek, Daniel, 5103 Möriken (CH); Hassan, Alia, 8122 Binz (CH); Graf, Stephan, 8050 Zürich (CH); Scheuzger, Peter, 8603 Schwerzenbach (CH)
(74) Vertreter: Kohler Schmid Möbus

(56) Entgegenhaltungen:
- US-A- 6 060 882
- US-B1- 6 175 237

## Beschreibung

Die Erfindung betrifft einen Kernspinresonanz-Messkopf umfassend mindestens zwei Spulen/Resonatoranordnungen A1 und A2, wobei mindestens eine der Spulen/Resonatoranordnungen A1 zwei sattelförmige Spulen S1 und S2 umfasst, wobei die Spulen jeweils ein Fenster aufweisen, um das N Windungen liegen, die in Serie geschaltet sind, mit N größer oder gleich 2, wobei die Spulen/Resonatoranordnungen A1 und A2 senkrecht zueinander orientiert sind,
und wobei die Spulen/Resonatoranordnungen A1 und A2 verschiedene Resonanzfrequenzen aufweisen.

Ein solcher Messkopf ist bekannt aus der US 6 175 237 und den dort zitierten Referenzen.

Aus der US 4, 739,269 ist eine bildgebende NMR-Apparatur bekannte die eine als Volumenspule ausgeführte Sendespule und eine als planare Oberflächenspule ausgeführte Empfangsspule aufweist. Um einen Eintrag von Störsignalen von außerhalb des Messvolumens zu vermeiden, ist die Empfangsspule symmetrisiert. Die Empfangsspule weist zwei in Serie geschaltete Windungen auf.

Die US 6,201,392 B1 beschreibt eine NMR-Sonde (NMR probe) mit mehreren Paaren von planaren Spulen, darunter wenigstens ein Paar HTS-Spulen. Die jeweils ersten Spulen eines jeden Paares sind koplanar ausgerichtet, und die jeweils zweiten Spulen eines jeden Paares sind koplanar ausgerichtet, wobei eine Kopplung der Spulenpaare minimiert wird.

Kernspinresonanz(=NMR)-Spektroskopie ist eines der leistungsfähigsten Verfahren der instrumentellen Analytik. Dabei werden elektromagnetische Pulse in eine Probe eingestrahlt, welche einem statischen Magnetfeld ausgesetzt ist. Aufgrund der Eigenschaften der Atomkerne in der Probe erfolgt eine charakteristische elektromagnetische Antwort der Probe.

In der Regel hat ein NMR-Messkopf eine, eventuell auch zwei bevorzugte Messfrequenzen, die zur Detektion eingesetzt werden. Weitere Messfrequenzen werden hauptsächlich zum Senden von Entkopplungspulsen verwendet. Diese dienen entweder dazu, Wechselwirkungen zwischen den zu observierenden Kernen und anderen Kernen in deren Umgebung aufzuheben, oder für "inverse Experimente", bei denen der Effekt einer Entkopplung von Kernen mit niedrigem gyromagnetischen Verhältnis γ im Spektrum eines Kernes mit hohem γ (insbesondere ¹H) untersucht wird.

Um den simultanen Betrieb auf mehreren Messfrequenzen zu ermöglichen werden in der Regel zwei ineinanderliegende Spulenanordnungen verwendet. Dabei wird zumindest eine der Detektions-Messfrequenzen auf der inneren Spulenanordnung plaziert und versucht, die Verluste dieser Spulenanordnungen zu minimieren. Dies führt zur Optimierung der Empfindlichkeit des Messkopfes bei der Detektion.

Eine Spulenanordnung besteht typischerweise aus zwei Spulen, die normalerweise mittels Zuleitungen parallel oder in Serie miteinander verschaltet sind. Es sind jedoch auch Spulenanordnungen realisierbar, die nicht galvanisch oder kapazitiv miteinander gekoppelt sind oder nur aus einer Spule bestehen. Komplizierte Spulenanordnungen sind aus einer Vielzahl von Spulen aufgebaut. Jede der Spulen kann mehrere Windungen umfassen, die ein Fenster umschliessen, und kann der Breite nach auf der Gesamtlänge oder auf beliebigen Teilabschnitten davon als ein Pfad oder als mehrere Parallelpfade ausgeführt sein und der Länge nach durch Kapazitäten und den Anschluss der Zuleitungen unterbrochen sein.

Die Windungen der Spulen untereinander können in Serie oder parallel verschaltet sein. Bei Mehrwindungsspulenanordnungen unterscheidet man daher Parallel-Parallel-Spulenanordnungen, Parallel-Seriell-Spulenanordnungen, Seriell-Seriell-Spulenanordnungen und Seriell-Parallel-Spulenanordnungen. Der erste Begriff bezeichnet die Verschaltung der Windungen innerhalb einer Spule, und der zweite Begriff bezeichnet die Verschaltung der beiden Spulen der Spulenanordnung.

Früher wurden in der NMR hauptsächlich Seriell-Seriell-Spulenanordnungen verwendet (siehe hierzu z.B. US 4 398 149). Diese haben eine relativ hohe Induktivität, so dass die verlustbehafteten Induktivitäten der Zuleitungen sowie die Zusatzinduktivitäten, die bei Multi-Frequenz-Messköpfen im Abstimmnetzwerk verwendet werden, im Verhältnis zur Spulenanordnung nicht ins Gewicht fallen. Dies führt zu hoher Effizienz der Spulen. Allerdings sind aufgrund der hohen Induktivitäten die Eigenresonanzen von Mehrwindungs-Seriell-Seriell-Spulenanordnungen zu tief für Hochfrequenz-NMR (Statisches Feld B₀ > 7 T). Dies führt zu schlechten HF-Feldhomogenitäten und Problemen, die Messfrequenzen für z.B. ¹³C und ³¹P überhaupt abstimmen zu können. Dieses Problem kann durch die geringere Induktivität von Mehrwindungs-Seriell-Parallel-Spulen gelöst werden (siehe z.B. US 6 175 237). Bei sehr grossen Messproben wie sie z.B. auch in der MRI (Kernspintomographie) auftreten, kann auch die Verwendung von Einwindungsspulen oder Parallel-Parallel-Spulen notwendig werden (siehe z.B. US 6 060 882). In diesem Fall können allerdings die Induktivitäten der Zuleitungen und des Netzwerkes schnell bedeutend grösser werden als diejenige der Spulenanordnung.

Neben Helmholz- und Sattelspulen finden in der NMR weitere Spulentypen Verwendung wie z.B. Solenoid-, Butterfly- und Meanderlinespulen sowie verschiedenste Formen von planaren Spulen.

Alternativ können im Messkopf auch Resonatoranordnungen verwendet werden, die aus einem oder mehreren Resonatoren bestehen können. Gängige Resonatoren in der NMR sind sogenannte Birdcages, Alderman-Grant-Resonatoren oder Transmissionline (Slotted-Tube)-Resonatoren, aber auch planare selbstresonante Strukturen wie z. B. Spiralresonatoren.

Um einen NMR-Messkopf für mehr als eine Betriebsfrequenz aufzubauen werden häufig Kombinationen von Spulen- und Resonatoranordnungen verwendet. Dies kann z. B. dadurch realisiert werden, dass eine erste Spulen- oder Resonatoranordnung konzentrisch in einer zweiten Spulen- oder Resonatoranordnung positioniert wird, und beide so ausgerichtet werden, dass die von ihnen erzeugten HF-Magnetfelder weitestgehend orthogonal zueinander stehen.

Ein wichtiges Ziel bei all diesen Anordnungen von Spulen- bzw. Resonatoranordnungen ist es, eine minimale Kopplung zwischen den Spulen- /Resonatoranordnungen zu erreichen. In der Folge soll, falls nicht ausdrücklich vermerkt, kein Unterschied zwischen einer Spulenanordnung und einer Resonatoranordnung gemacht werden, da die Betrachtungen für beide äquivalent sind.

Eine Kopplung zwischen den mindestens zwei verwendeten Spulenanordnungen ist in vielerlei Hinsicht nicht wünschenswert:
1. Durch Kopplung wird im Resonanzfall Strom von der einen Spulenanordnung auf die andere verlegt. Bei der "inneren" Spulenanordnung werden dadurch die Ströme von der Messprobe entfernt, die Effizienz der Anordnung reduziert und somit die Empfindlichkeit des Messkopfes bei der/den Messfrequenzen, die auf der inneren Spulenanordnung schwingen, reduziert.
2. Falls eine Spulenanordnung eine deutlich höhere Güte aufweist als eine andere, dann führt eine residuelle Kopplung zu einer starken Dämpfung der Spulenanordnung mit höherer Güte. Dies tritt insbesondere dann auf, wenn z.B. in einer Spulenanordnung supraleitende Materialien verwendet werden, wohingegen in der anderen lediglich Normalleiter eingesetzt werden.
3. Bei vernachlässigbarer Kopplung zwischen den Spulenanordnungen kann jede unabhängig auf die mindestens eine Messfrequenz abgestimmt werden. Dies vereinfacht einerseits den Bau des Messkopfes und andererseits auch den Abstimmvorgang bei Probenwechsel im Betrieb.
4. Bei vernachlässigbarer Kopplung ist kein Übersprechen zwischen Messkanälen messbar. Dies erleichtert z.B. Entkopplungsexperimente.

Insbesondere bei Mehrwindungs-Seriell-Parallel-Spulensystemen des Standes der Technik, wie sie in der US 6 175 237 und den dort zitierten Referenzen beschrieben sind, kann die Kopplung von zwei Spulensystemen (Spulenanordnungen) zwar auf ein Minimum eingerichtet werden, die Kopplung kann aber nicht ausgelöscht werden.

Es ist daher die Aufgabe der Erfindung, einen Kernspinresonanz-Messkopf zur Verfügung zu stellen, bei dem die Kopplung zwischen zwei Spulen/Resonatoranordnungen weiter verringert ist.

Diese Aufgabe wird erfindungsgemäß durch einen Kernspinresonanz-Messkopf der eingangs vorgestellten Art gelöst, der dadurch gekennzeichnet ist, dass die Spulen S1 und S2 jeweils bezüglich einer Mittelebene der jeweiligen Spule, die senkrecht auf dem Fenster der jeweiligen Spule steht, spiegelsymmetrisch aufgebaut sind, wobei die Spulen S1, S2 jeweils wenigstens N-1 Kreuzungspunkte zwischen Leiterabschnitten aufweisen, wobei diese Kreuzungspunkte auf der Mittelebene der jeweiligen Spule angeordnet sind, und dass die Mittelebenen der Spulen S1 und S2 identisch sind, so dass die elektromagnetische Kopplung zwischen den zwei Spulen/Resonatoranordnungen A1 und A2 bei der Resonanzfrequenz von A2 minimal ist.

Spiegelsymmetrisch bedeutet hier, dass zu jedem Punkt auf dem Leiter der Spule ein spiegelsymmetrisch angeordneter Punkt auf dem Leiter existiert, insbesondere wobei der jeweils von dem Punkt und seinem Spiegelpunkt auf dem Leiter zurückzulegende Weg zu jedem beliebigen Schnittpunkt der Spule mit der Mittelebene (insbesondere zu jedem beliebigen Kreuzungspunkt auf der Mittelebene) jeweils gleich lang ist. Eine Spule wird auch dann noch als spiegelsymmetrisch betrachtet, wenn eine geometrische Symmetrie vorliegt, die lediglich an Kreuzungspunkten von Leiterabschnitten oder durch leichte parallele oder radiale Abweichungen gebrochen ist. Letztere können z. B. durch Verwendung von zwei Leiterschichten, die auf unterschiedlichen Seiten eines Substrates aufgebracht sind, entstehen.

Konkret erfolgt die Beurteilung der Spiegelsymmetrien erfindungsgemäß bei planaren Spulen, die aus mehreren Leiterebenen bestehen und deren Ebenenabstand sehr viel kleiner (insbesondere wenigstens Faktor 5-10, besser einen Faktor 100) ist als die Abmessungen der Spule in diesen Leiterebenen, dergestalt, dass der gesamte Leiter als in der selben Ebene liegend angesehen wird. Asymmetrien, die durch die Verwendung von mehreren Leiterebenen an sich oder einen Übergang eines Leiterabschnitts zu einer anderen Ebene entstehen, werden im Rahmen der Erfindung vernachlässigt. Bei sattelförmigen Spulen, die aus mehreren "Leiterebenen" bestehen, erfolgt die Beurteilung äquivalent zu den planaren Spulen, wenn der Abstand zwischen den zylindermantelförmigen Leiterflächen sehr viel kleiner ist als die Abmessungen der Spule.

Die zwei Spulen-/Resonatoranordnungen werden im Rahmen der Erfindung als senkrecht zueinander orientiert angesehen, wenn sie unter einem Winkel von 90°+/- 5° ausgerichtet sind. Bei diesen Winkelbereichen ist die Kopplung zwischen den beiden Spulen-/Resonatoranordnungen besonders gering. Bevorzugt ist ein Winkel von möglichst genau 90°. Der Winkel zwischen zwei Spulen-/Resonatoranordnungen bezieht sich auf den Winkel zwischen den im Betrieb von den Spulen erzeugten HF-Magnetfelder.

Wie weiter unten noch erörtert wird, kann die Kopplung zwischen einer symmetrischen Spule S1, S2 und einer weiteren Spulenanordnung A2 unter bestimmten Voraussetzungen weitestgehend ausgelöscht werden. Eine im Rahmen der Erfindung gestaltete Spulenanordnung A1 beeinflusst ein anderes Spulensystem A2 weit weniger als Spulenanordnungen gemäß dem Stand der Technik.

Bei dem erfindungsgemäßen Kernspinresonanz-Messkopf weisen die Spulen S1, S2 jeweils wenigstens N-1 Kreuzungspunkte zwischen Leiterabschnitten auf, wobei diese Kreuzungspunkte auf der Mittelebene der jeweiligen Spule angeordnet sind. Dies ist eine einfache Möglichkeit, eine Spule mit elektrischer Symmetrie aufzubauen. An einem Kreuzungspunkt überlappen zwei Leiterabschnitte, ohne einen elektrischen Kontakt zwischen diesen beiden Leiterabschnitten herzustellen. Mit Leiterabschnitt wird ein elektrisch leitfähiger Abschnitt einer Spule bezeichnet.

Wenn ein Leiterabschnitt zwei oder mehr weitere Leiterabschnitte kreuzt, so wird dies hier als entsprechend zwei oder mehr Kreuzungspunkte verstanden.

Bevorzugt ist eine Ausführungsform des erfindungsgemäßen Kernspinresonanz-Messkopfs, bei der die Spulen S1 und/oder S2 jeweils 2*J weitere Kreuzungspunkte von Leiterabschnitten aufweisen, wobei die weiteren Kreuzungspunkte paarweise symmetrisch zur jeweiligen Mittelebene liegen, mit J größer oder gleich 1. Diese Geometrie reduziert die magnetische Kopplung einer Spulenanordnung bei höheren Schwingungsmoden.

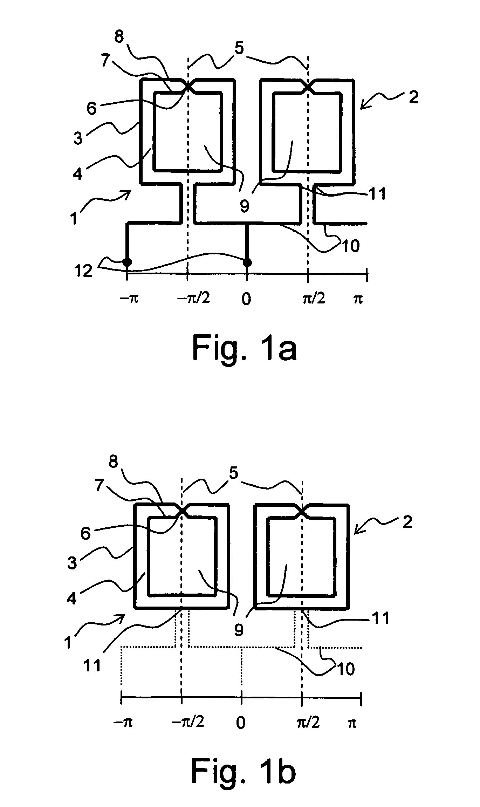

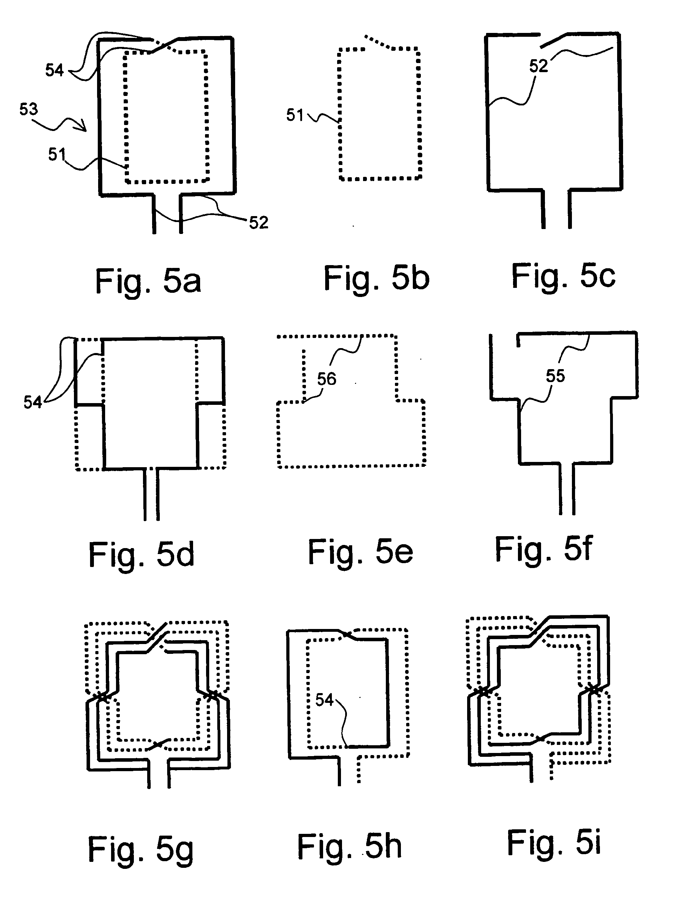

Die Kreuzungen von Leiterabschnitten können unter jedem beliebigen Winkel zwischen 0° und 180° realisiert werden. Bei einem Winkel von 90° ist der Kreuzungspunkt auf die Leiterbreite limitiert. Je kleiner oder grösser der Winkel wird, desto mehr weitet sich der Kreuzungspunkt aus. Im Extremfall kann der Kreuzungspunkt die volle Ausdehnung der Spule einnehmen. Beide Extreme sind in Fig. 5d erläutert: oben eine Kreuzung unter 0°, auf den Seiten eine Kreuzung unter 180°. Eine Kreuzung unter 90° führt zur geringst möglichen Kapazität am Kreuzungspunkt und damit der höchstmöglichen Eigenresonanz bei gegebener Spulengeometrie. Sie ist z.B. in Fig. 1a dargestellt. Eine Kreuzung unter 0° führt zu kleinst möglichen Dimensionen, was insbesondere in z-Richtung wünschenswert ist. Eine Kreuzung unter 180° führt zu grösstmöglicher HF-Feld-Homogenität in der xy-Ebene.

Bevorzugt wird weiterhin eine Ausführungsform, bei der die Spulen S1, S2 so aufgebaut sind, dass sich bei Betrieb der Spulen im Resonanzfall eine bezüglich der jeweiligen Mittelebene spiegelsymmetrische, aber gegengleiche Potentialverteilung auf der jeweiligen Spule S1, S2 einstellt.

Vorteilhaft ist eine Ausführungsform eines erfindungsgemäßen Kernspinresonanz-Messkopfs, bei dem die Spulen S1 und/oder S2 jeweils als Drahtspule ausgeführt sind. In diesem Fall sind Kreuzungspunkte durch Biegen eines Drahtes herstellbar, und es ist keine besondere Verbindungstechnik für Kreuzungspunkte notwendig.

Eine vorteilhafte, alternative Ausführungsform sieht vor, dass die Spulen S1 und/oder S2 jeweils als Folien- oder Dünnschichtspule ausgeführt sind. Hier ist die automatisierte Fertigung besonders einfach. Bei einer Folienspule werden der Leiter aus Metallfolie gearbeitet (durch Schneiden, Ätzen, etc) und auf ein Substrat aufgebracht (durch Kleben, Pressen, Verschmelzen etc.). Bei einer Dünnschichtspule wird die Metallisierung direkt auf das Substrat aufgebracht (z.B. durch Verdampfen, Sputtern, galvanisch, etc.).

Eine bevorzugte Weiterbildung dieser Ausführungsform sieht vor, dass Kreuzungspunkte und/oder weitere Kreuzungspunkte mittels aufgelöteter oder aufgeschweißter Brücken ausgeführt sind. Dann kann ein "Schießen" der Spule am Kreuzungspunkt durch Variieren der Überstandsdicke kontrolliert werden.

Bei einer weiteren, bevorzugten Weiterbildung der obigen Ausführungsform sind die Spulen S1 und/oder S2 jeweils als Folienspule aus flexiblem PCB(=printed circuit board)-Material ausgeführt. Das vereinfacht die Herstellung. Das Dielektrikum des PCB-Materials kann aus Kunststoff, Keramik, Glas, Halbleiter, Oxiden, Nitriden, etc. hergestellt sein. Die Metallisierung kann durch Verkleben, Verschmelzen, Aufdampfen, Sputtern, Galvanik etc aufgebracht sein.

Eine Weiterentwicklung dieser Weiterbildung ist dadurch gekennzeichnet, dass die Spulen S1 und/oder S2 jeweils aus wenigstens N Spulenabschnitten aufgebaut sind, die auf unterschiedlichen Ebenen angeordnet sind, und dass wenigstens N-1 Durchkontaktierungen durch das Dielektrikum vorgesehen sind, die jeweils zwei Spulenabschnitte miteinander elektrisch verbinden. Die Durchkontaktierung ist eine besonders einfache Art des Verbindens von Leiterabschnitten auf verschiedenen Ebenen.

Eine andere, bevorzugte Ausführungsform sieht vor, dass eine Durchkontaktierung nicht an einem Kreuzungspunkt in der jeweiligen Spule S1 und/oder S2 angeordnet ist.

Besonders bevorzugt ist eine Ausführungsform eines erfindungsgemäßen Kernspinresonanz-Messkopfs, wobei bei der Spulen/Resonatoranordnung A1 die zwei Spulen S1, S2 parallel geschaltet sind. Diese Spulenanordnung A1 ist als eine Seriell-Parallel-Spulenanordnung im NMR-Messkopf einsetzbar, die zur zweiten Spulen- oder Resonatoranordnung A2 im Messkopf eine minimale Kopplung aufweist. Bevorzugt sind die Spulen der Spulenanordnung A1 baugleich und spiegelsymmetrisch zueinander angeordnet, sie können aber auch unterschiedlicher Bauart sein.

Eine weitere Ausführungsform sieht vor, dass die zweite Spulen/Resonatoranordnung A2 wenigstens eine planare oder sattelförmige Spule S3 umfasst, wobei die Spule S3 ein Fenster aufweist, um das N Windungen liegen, die in Serie geschaltet sind, mit N größer oder gleich 2, wobei die Spule S3 bezüglich einer Mittelebene der Spule S3, die senkrecht auf dem Fenster steht, spiegelsymmetrisch aufgebaut ist.

Bei einer bevorzugten Ausführungsform des erfindungsgemäßen Kernspinresonanz-Messkopfs ist die Spulen/Resonatoranordnung A2 als Birdcageresonator ausgeführt. Birdcage-Resonatoren sind in der Praxis bewährt und können besonders hohe Symmetrien aufweisen (im Idealfall zwei elektrische und eine magnetische Symmetrie).

Schließlich ist auch eine Ausführungsform eines erfindungsgemäßen Kernspinresonanz-Messkopfs bevorzugt, die dadurch gekennzeichnet ist, dass Impedanzen an den Zuleitungen der Spulen/Resonatoranordnung A1 so gewählt sind, dass sich bei Resonanzfrequenz der anderen Spulen/Resonatoranordnung A2 symmetrische Potentiale an den Zuleitungen der Spulen/Resonatoranordnung A1 einstellen. Mit anderen Worten: An der erfindungsgemäß symmetrisierten Mehrwindungs-Spulenanordnung stellen sich symmetrische Potentiale an den Zuleitungen ein, wenn an der anderen Spulen/Resonatoranordnung (die ebenfalls erfindungsgemäß symmetrisiert sein kann) ein Betrieb in Resonanz erfolgt. Dies bedingt einen symmetrischen Aufbau der Zuleitungen zumindest in dem Bereich, in dem nicht vernachlässigbare Kopplungen zwischen den Zuleitungen der äusseren Spulenanordnung und der inneren Spulenanordnung existieren.

Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung näher dargestellt und erläutert. Es zeigt:
- Fig. 1 a: eine Spulenanordnung für einen erfindungsgemäßen Magnetresonanz-Messkopf, in Abwicklung dargestellt, umfassend zwei Spulen mit jeweils zwei seriellen Windungen und einem Kreuzungspunkt sowie den Zuleitungen;
- Fig. 1 b: die Spulenanordnung aus Fig. 1a, bei der die Spulen (durchgezogene Linien) dargestellt sind bevor sie durch den Anschluss der Zuleitungen (gepunktete Linien) unterbrochen wurden;
- Fig. 2: eine Spule für einen erfindungsgemäßen Magnetresonanz-Messkopf , mit drei seriellen Windungen und zwei Kreuzungspunkten;
- Fig. 3a: einen Magnetresonanz-Messkopf gemäß dem Stand der Technik mit nicht-symmetrischer Potentialverteilung einer Spulenanordnung im Resonanzfall eines Birdcageresonators;
- Fig. 3b: einen erfindungsgemäßen Magnetresonanz-Messkopf mit einer Spulenanordnung mit symmetrischen Zuleitungen und symmetrischer Potentialverteilung im Resonanzfall eines Birdcageresonators;
- Fig. 3c: eine Spulenanordnung für einen erfindungsgemäßen Magnetresonanz-Messköpf mit symmetrisch abgegriffenen jedoch asymmetrisch ausgeführten Zuleitungen;
- Fig. 3d: eine Spulenanordnung für einen erfindungsgemäßen Magnetresonanz-Messkopf ohne Zuleitungen zur induktiven Ankopplung;

- Fig. 3e: eine Spulenanordnung für einen erfindungsgemäßen Magnetresonanz-Messkopf ohne Zuleitungen, für den Betrieb mit zwei Resonanzfrequenzen;
- Fig. 4a: eine Spule für einen erfindungsgemäßen Magnetresonanz-Messkopf , mit zwei seriellen Windungen und drei Kreuzungspunkten;
- Fig. 4b: eine Spule für einen erfindungsgemäßen Magnetresonanz-Messkopf , mit zwei seriellen Windungen, die teilweise aus einer Parallelschaltung von zwei Leiterpfaden besteht.
- Fig. 4c: eine Spule für einen erfindungsgemäßen Magnetresonanz-Messkopf , mit zwei seriellen Windungen, wovon die innere Windung aus zwei Parallelpfaden besteht, die auf der Mittelebene gekreuzt sind;
- Fig. 4d: eine Spule für einen erfindungsgemäßen Magnetresonanz-Messkopf , mit zwei seriellen Windungen, bei der die "Stangen" als zwei gekreuzte Parallelpfade ausgeführt sind;
- Fig. 4e: eine Spule für einen erfindungsgemäßen Magnetresonanz-Messkopf , nämlich eine Zweiwindungs-Seriespule, bei der der Leiter über die volle Länge als zwei Parallelpfade ausgeführt ist;
- Fig. 4f: eine Spule für einen erfindungsgemäßen Magnetresonanz-Messkopf , nämlich eine Zweiwindungs-Seriespule, bei der der Leiter über die volle Länge als zwei Parallelpfade ausgeführt ist und 13 Kreuzungspunkte zwischen Leitern ausgeführt sind;

- Fig. 5a: eine Spule für einen erfindungsgemäßen Magnetresonanz-Messkopf, die als Folienspule auf PCB-Material mit zwei Leiterebenen ausgeführt ist, wobei die Leiterabschnitte der beiden Leiterebenen gepunktet bzw. durchgezogen dargestellt sind;
- Fig. 5b: den Leiterabschnitt der ersten Leiterebene von Fig. 5a;
- Fig. 5c: die Leiterabschnitte der zweiten Leiterebene von Fig. 5a;
- Fig. 5d: eine Spule für einen erfindungsgemäßen Magnetresonanz-Messkopf ähnlich Fig. 5a mit drei Kreuzungspunkten und zwei Durchkontaktierungen, die nicht an den Kreuzungspunkten ausgeführt sind. Die Leiterabschnitte der beiden Leiterebenen sind gestrichelt bzw. durchgezogen dargestellt;
- Fig. 5e: den Leiterabschnitt der ersten Leiterebene von Fig. 5d;
- Fig. 5f: die Leiterabschnitte der zweiten Leiterebene von Fig. 5d;
- Fig. 5g: eine erste Ausführungsform auf PCB-Material der Spule aus Fig. 4f mit dreizehn Kreuzungspunkten und fünf Durchkontaktierungen;
- Fig. 5h: eine alternative Ausführungsform der Spule aus Fig. 5a mit einem Kreuzungspunkt und einer einzigen Durchkontaktierung;
- Fig. 5i: eine zweite Ausführungsform der Spule auf Fig. 4f mit dreizehn Kreuzungspunkten und lediglich zwei Durchkontaktierungen.

### Einführung

Sattelspulen und Helmholtzspulensysteme sind in der Kernspinresonanz seit langem bekannt. Eine Sattelspule ist eine Spule, die aus bogenförmigen Querelementen und stangenförmigen Längselementen besteht. Sie ist so strukturiert, dass sie (mit Ausnahme eventueller Kreuzungspunkte zwischen Leiterabschnitten) auf einer zylindermantelförmigen Fläche liegt.

In der NMR werden in der Regel zwei oder mehr Messfrequenzen verwendet. Eine Möglichkeit der Realisierung eines Magnetresonanz (MR)-Probenkopfes für mehr als eine Messfrequenz ist es, zwei verschiedene Spulenanordnungen zu verwenden, die jeweils auf eine oder mehrere Resonanzfrequenzen abgestimmt sind. Hierbei unterscheidet man Anordnungen von Resonatoren und Spulen. Die verwendeten Resonatoren sind in der Regel aus der Gruppe der Birdcage- oder Alderman-Grant-Resonatoren, wohingegen die verwendeten Spulen in der Regel Sattelspulen sind. Insbesondere in der Festkörper NMR sowie bei Verwendung von Flusszellen werden auch Solenoidspulen verwendet.

Spezielle Messköpfe verwenden auch planare Spulen und Resonatoren. Beispiele hierfür sind einerseits Messköpfe für extrem masselimitierte Proben, bei denen Oberflächenspulen (Spiralen, Butterfly und Meanderline) eingesetzt werden aber auch Messköpfe, bei denen das Detektionssystem auf kryogene Temperaturen gekühlt wird und deren Resonatoren aus Hochtemperatursupraleitermaterial gefertigt sind.

Werden zwei Spulen/Resonatoranordnungen in einem Probenkopf montiert, so werden diese gemäss Stand der Technik so konzipiert, dass sie konzentrisch montiert werden und durch das Ausrichten unter 90° zu einander keine induktive Kopplung aufweisen sollen. Die Konzeption der Mehrwindungsspulen gemäß Stand der Technik geht davon aus, das Kopplungen zwischen zwei Spulen/Resonatoranordnungen eliminiert werden können, wenn jede Spulenanordnung lediglich weitestgehend eine magnetische Symmetrie aufweist.

In der Elektrodynamik versteht man unter einer elektrischen Symmetrieebene eine Ebene, die keine tangentialen E-Felder aufweist, d.h. die E-Felder stehen senkrecht auf der Ebene. Eine magnetische Symmetrieebene hingegen zeichnet sich durch verschwindende tangentiale H-Felder, aus, d.h. das H-Feld steht senkrecht auf der magnetischen Symmetrieebene.

Z.B. im Falle der Spulenanordnung in Fig. 1 aus US 6 175 237 definiert die Ebene, die durch die Mitte von Element 30 sowie zwischen den Elementen 16 und 26 verläuft eine magnetische Symmetrieebene. Die Spulenanordnung weist keine weitere Symmetrieebene auf. Weiterhin weisen die einzelnen Spulen (10, 20) keine Symmetrie auf.

Ohne Verletzung der Allgemeingültigkeit wird im Folgenden angenommen, dass ein Magnetresonanz (MR)-Aufbau vorliegt, bei dem eine innere Spulen/Resonatoranordnung maximale elektrische und magnetische Symmetrien aufweist. Dies bedeutet, dass diese Spulen/Resonatoranordnung zumindest eine elektrische und eine magnetische Symmetrie aufweist. Die dritte Symmetrieebene, die ebenfalls eine elektrische Symmetrie aufweisen sollte, kann in der Regel aufgrund von Zuleitungen nicht perfekt realisiert werden. Um diese innere Spulenanordnung soll eine zweites Spulensystem platziert werden, das dergestalt ist, dass beide Spulenanordnungen nicht oder nur unwesentlich miteinander koppeln. Ohne Verletzung der Allgemeinheit könnte die Montage auch andersherum erfolgen, d.h. die zu betrachtende Spulenanordnung läge im Inneren.

Das Minimieren der Kopplung zwischen beiden Spulenanordnungen hat folgende Vorzüge:
1. Die beiden Spulenanordnungen beeinflussen sich minimal, d.h. Frequenz, Güte und Effizienz der jeweiligen Spulenanordnungen sind weitestgehend unabhängig von der Präsenz der zweiten Spulenanordnung.
2. Die Resonanzmoden der einzelnen Messfrequenzen sind auf die Spulenanordnung, auf der sie eingekoppelt werden, begrenzt. D.h. bei Anregung einer Resonanz fließen keine oder kaum Ströme auf der zweiten Spulenanordnung.
3. Das Übersprechen von einem Kanal in den nächsten wird deutlich reduziert, zumindest wenn die beiden Kanäle auf verschiedenen Spulenanordnungen angeschlossen sind.
4. Das Netzwerk wird vereinfacht, da auf Sperrkreise verzichtet werden kann, die Übersprechen, Kopplungen und Fehlresonanzen verbessern sollen.

Die Auslöschung der Kopplungen zwischen den beiden Spulenanordnungen kann bei Ein- und Mehrwindungs-Parallel-Parallel-Spulen sehr gut funktionieren. Bei Seriell-Parallel und Parallel-Seriell, sowie Seriell-Seriell-Spulen stellt man in der Realität rasch fest, dass durch Ausrichten lediglich ein Minimum gefunden und die Kopplung nicht ausgelöscht werden kann.

### Erfindungsgemäße Verbesserung der Auslöschung der Kopplung

Im Rahmen der vorliegenden Erfindung wurde herausgefunden, dass die erwähnten Serie-Spulen ein gemeinsames Problem aufweisen: Die Spulen haben keine Symmetrie, was zu residuellen Kopplungen zwischen den mindestens zwei Spulenanordnungen eines Messkopfes führt. Die Erfindung zeigt eine Möglichkeit auf, wie die verbleibenden Kopplungen auch (zumindest weitestgehend und für gewisse Moden) ausgelöscht werden können. Eine erfindungsgemäß gestaltete erste Spulenanordnung A1 mit sattelförmigen Spulen S1, S2 beeinflusst eine zweite Spulenanordnung A2 weit weniger als Spulen gemäss Stand der Technik.

Die Reduktion der Kopplungen wird erreicht, wenn eine Mehrwindungs-Serie-Spule S1, S2 so ausgeführt wird, dass die Spule eine (geometrische) Symmetrie besitzt und insbesondere N-1 oder mehr (wobei N die Windungszahl ist) Kreuzungspunkte zwischen Leiterabschnitten aufweist, wobei die Kreuzungspunkte entweder auf der Symmetrieebene oder paarweise symmetrisch zu dieser liegen. Dabei müssen aber N-1 Kreuzungspunkte auf der Symmetrieebene liegen, und die etwaigen weiteren Kreuzungspunkte müssen paarweise symmetrisch zu dieser liegen.

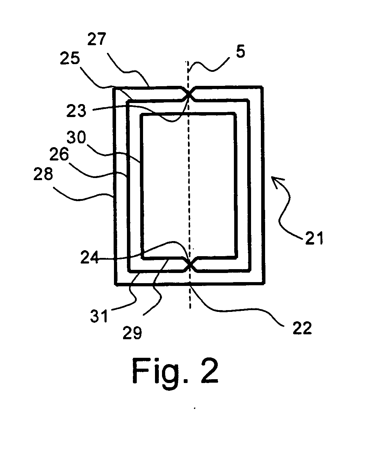

Die Fig. 1a zeigt dies für Zweiwindungsspulen, und Fig. 2 für Dreiwindungsspulen. Die Symmetrie wird entweder eingehalten, wenn die beiden Spulen unabhängig geschaltet werden (z.B. durch induktive Einkopplung) oder wenn sie parallel angeschlossen werden.

In **Fig. 1a** ist eine Spulenanordnung für einen erfindungsgemäßen Magnetresonanz-Messkopf in Abwicklung dargestellt, die zwei Spulen S1, S2, bezeichnet auch mit Bezugszeichen 1, 2 umfasst. Die Geometrie beider Spulen 1, 2 wird beispielhaft an der Spule 1 erläutert. Die Spule 1 weist zwei Windungen 3, 4 auf, die in Serie geschaltet sind. Die Spule 1 ist spiegelsymmetrisch bezüglich einer Mittelebene 5, die senkrecht zur Zeichnungsebene verläuft. An einem Kreuzungspunkt 6 wird ein Leiterabschnitt 7 der inneren Windung 4 nach außen geführt und ein Leiterabschnitt 8 der äußeren Windung 3 wird nach innen geführt. Dabei überlappen sich die Leiterabschnitte 7, 8 am Kreuzungspunkt 6. Der Leiterabschnitt 7 wird über den Leiterabschnitt 8 hinweggeführt, ohne dass zwischen den Leiternabschnitten 7, 8 eine elektrisch leitfähige Verbindung entsteht. Der Kreuzungspunkt 6 liegt auf der Mittelebene 5. Es kann selbstverständlich auch einer der beiden Leiterabschnitte 7 oder 8 in der Spulenfläche bleiben und lediglich der zweite nach innen oder nach außen geführt werden. Die innere Windung 4 umschließt ein Fenster 9 der Spule 1.

In **Fig. 1b** ist die Spulenanordnung aus Fig. 1a dargestellt, bevor sie zusammengefügt wurde. Die Zuleitungen 10 sind als gepunktete Linien, die beiden Spulen 1, 2 als durchgezogene Linien gezeichnet. Die Spulen 1 und 2 sind an den Anschlusspunkten 11 der Zuleitungen 10 noch nicht unterbrochen.

Fig. 2 zeigt eine Spule S1, S2 für einen erfindungsgemäßen Magnetresonanz-Messkopf, nämlich eine Spule 21, die drei Windungen 26, 28, 30 aufweist. Die Spule 21 weist zwei Kreuzungspunkte 23, 24 auf. Am oberen Kreuzungspunkt 23 überkreuzen sich ein Leiterabschnitt 25 der mittleren Windung 26 und ein Leiterabschnitt 27 der äußeren Windung 28. Am unteren Kreuzungspunkt 24 überkreuzen sich ein Leiterabschnitt 31 der mittleren Windung 26 und ein Leiterabschnitt 29 der inneren Windung 30. Die Kreuzungspunkte 23, 24 liegen wiederum auf einer Mittelebene 5. Soll die Spule 21 mittels eines Kondensators auf Resonanz eingestellt werden oder Zuleitungen angebracht werden, so bietet sich der Punkt 22 zum Unterbrechen des Leiters an.

In den Figuren 1a, 1b und 2, ebenso wie in den nachfolgenden Abbildungen, sind Spulen und Spulenanordnungen dahingehend vereinfacht dargestellt, dass eine etwaige gewölbte Form der Spule, beispielsweise belegend z. B. eine zylindermantelförmige Fläche, in einem abgewickelten Zustand dargestellt werden. Die z-Achse zeigt nach oben, die x-Achse ragt bei "0" und die y-Achse bei "π/2" jeweils aus der Zeichenebene heraus, vgl. Fig. 1a. X, y, z bilden ein orthogonales System.

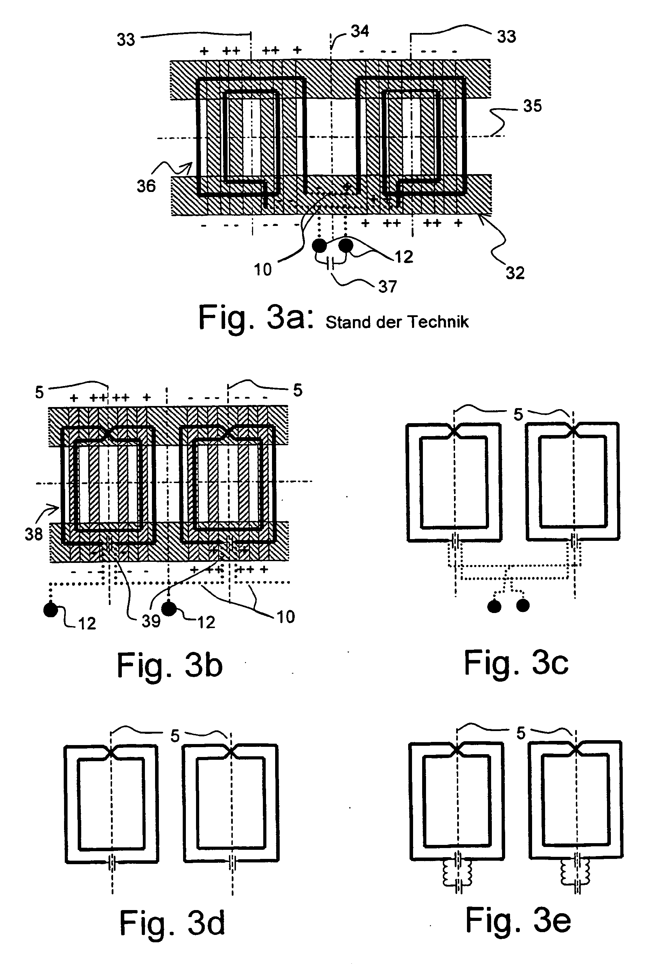

In Fig. 3a und 3b ist jeweils ein Magnetresonanz-Messkopf dargestellt, umfassend eine (äußere) Spulenanordnung A1 und einen (inneren) Birdcage(BC)-Resonator A2, mit Bezugszeichen 32, dargestellt. Die Spulen 36, 38 der äußeren Spulenanordnung A1 sind mit durchgezogenen Linien gezeichnet, wohingegen die Zuleitungen10 gepunktet dargestellt sind. Der BC 32 bzw. A2 ist schraffiert dargestellt. Der BC 32 soll maximale Symmetrien aufweisen, d.h. die yz-Ebene ist eine magnetische Symmetrieebene 33 des BC und die xz- sowie xy-Ebenen sind elektrische Symmetrieebenen 34 und 35 des BC 32.

Die Fig. 3a und 3b stellen die Potentialverteilung auf dem inneren BC-Resonator 32 zu einem Zeitpunkt während des Betriebs dar: Die Potentiale sind symmetrisch zur Symmetrieebene 33 und antisymmetrisch zu den beiden Ebenen 34 und 35.

Betrachten wir nun die Potentiale auf der äußeren Spule 36, 38, so stellen sich Potentiale ein wie in Fig. 3a und 3b dargestellt ist (Je weiter entfernt die äußeren Spulen vom BC montiert werden, desto geringer werden die Absolutwerte der Potentiale auf den Spulen ausfallen).

Die Betrachtung der Potentiale auf einem vollsymmetrischen Birdcage ist lediglich eine repräsentative Darstellung der Potentiale, die durch das Erzeugen eines HF-Magnetfeldes im Raum entstehen. Wird das Feld mittels Spulen- oder Resonatoranordnungen mit geringerer Symmetrie erzeugt, so werden die Symmetrien der Felder entsprechend geringer ausfallen.

Betrachten wir nun die Potentiale auf der äußeren Spulenanordnung A1 bzw. der Spule 36 gemäß Stand der Technik (**Fig. 3a**): Bei einer Betrachtung, bei der zunächst allfällige Resonanzen der äußeren Spule 36 außer Betracht genommen werden, darf davon ausgegangen werden, dass die Potentiale, die sich beim Betrieb des inneren Resonators 32 auf den äußeren Spulen 36 einstellen, denen der nächstgelegenen metallischen Elemente des Resonators 32 annähern, und zwar um so stärker, je geringer der Abstand ist. Daraus folgt, dass an den beiden Anschlusspunkten 12 der beiden Spulen 36 unterschiedliche Potentiale anliegen (+ und ++ bzw - und --). Würde man jede Spule 36 einzeln mittels jeweils eines Kondensators elektrisch schließen, so würde beim Betrieb des inneren Sputensystems ein Strom durch diesen Kondensator in den Zuleitungen jeder der beiden äußeren Spulen 36 fließen.

Diese Potentialdifferenz zwischen den beiden Spulen 36 einer Spulenanordnung A1 führt dazu, dass in beiden Zuleitungen 10 Ströme in dieselbe Richtung fließen, wenn die beiden Spulen 36 der Spulenanordnung mittels Zuleitungen 10 verbunden werden. Ist der Kondensator 37 jeweils "mittig" angeschlossen, so fließen über ihn keine Ströme; ist er nicht "mittig" angeschlossen, wie in Fig. 3a, so fließt ein Teil der Ströme jeweils noch über den Kondensator 37. Die Felder, die durch die Ströme in den Zuleitungen entstehen sind in dieselbe Richtung gerichtet, wie die Felder des inneren Resonators 32, d.h. die Zuleitungen 10 koppeln stark induktiv mit dem Resonator. Die Ströme, die beim Betrieb des inneren Resonators 32 in der Spulenanordnung gemäß des Standes der Technik erzeugt werden, führen wie eingangs dargestellt zu einer Vielzahl von unerwünschten Eigenschaften des Messkopfes.

Die Verbindung zwischen zwei Spulen 36 einer Spulenanordnung A1 gemäß Stand der Technik wird in der Regel so konzipiert, dass für den Betrieb der Spulenanordnung A1 die Zuleitungen 10 kein magnetisches Feld produzieren. D.h. werden die Zuleitungen im "differential mode" betrieben löschen sich die von ihnen erzeugten Felder ab einer Distanz von ca. dem Abstand der Leiter voneinander weitestgehend aus.

Bei der Resonanzfrequenz der inneren Spulenanordnung 32 bzw. A2 fließen jedoch Ströme im "common mode" auf den Zuleitungen 10. D.h. die Felder, die durch die Zuleitungen 10 erzeugt werden, können sich nicht auslöschen und die beiden Spulenanordnungen A1, A2 koppeln zusätzlich über die Zuleitungen 10.

Eine zusätzliche Spannung kann auch gemäß des Ampèreschen Gesetzes durch induktive Kopplung aufgrund der Asymmetrie der Spulen 36 induziert werden. Die Tatsache, dass bei Spulen 36 des Standes der Technik die Kreuzungspunkte nicht auf der magnetischen Symmetrieebene 32 des inneren Spulensystems liegen, sondern in einer Region, in der beim Betrieb des BC-Resonators 32 ein relativ hoher Feldgradient auftritt, führt zu einer unterschiedlichen Kopplung zwischen innerer und äußerer Windung. Die Kopplungen können sich nicht mehr gegenseitig aufheben und jede Spule 36 für sich genommen, wie auch die zusammengeschaltete Spulenanordnung gemäß Fig. 3a, koppelt induktiv mit dem Resonator 32.

In einem MR-Messkopf wird in der Regel ein Netzwerk an den Zuleitungen 10 der Spulenanordnung A1 angeschlossen. Gemäß der obigen Ausführungen sind die Anschlusspunkte 12 des Netzwerkes an die Zuleitungen 10 bei Spulen gemäß Stand der Technik nicht potentialfrei. D.h. beim Betrieb des inneren Resonators 32 A2 entstehen Spannungen über den Anschlusspunkten 12 des Netzwerkes der äußeren Spulenanordnung A1. Diese Kopplung führt in der Praxis dazu, dass zum Entkoppeln der einzelnen Messfrequenzen und Vermeiden von Verlusten durch "Fehlresonanzen" im Abstimmnetzwerk ein Sperrfilter in den Anschlüssen des Netzwerkes notwendig wird. Diese Sperrfilter führen zu zusätzlichen Verlusten bei Resonanz des Resonators 32 A2.

Bei einem symmetrischen Anschluss der Zuleitungen werden die Anschlusspunkte 12 des Netzwerkes auch potentialfrei. Es fließt jedoch eine Ringstromkomponente, da in der "oberen" Zuleitung weniger Strom fließt als in der "unteren". D.h. es fließt ein zusätzlich zum common-mode noch ein Strom aufgrund der Potentialdifferenz an den Anschlussbeinen, der zu unnötigen Verlusten führt.

Betrachten wir nun den Fall des erfindungsgemäßen MR-Probenkopfs mit gemäß der Erfindung ausgestatteter Spulenanordnung A1, dargestellt in **Fig. 3b****:** Durch den symmetrischen Aufbau der beiden Spulen S1, S2, mit Bezugszeichen 38, der Spulenanordnung A1 haben die Anschlussbeine jeder Spule 38 identische Potentiale (+, + bzw -, -).

Werden die Anschlusspunkte 11 einer Spule 38 mittels eines Kondensators 39 für HF-Strorn geschlossen, so fließt bei der Spule 38 kein Strom über diesen.

Werden die beiden Spulen 38 der Spulenanordnung A1 in Fig. 3b nun ebenfalls mittels Zuleitungen 10 verbunden, so fließen auch in diesem Fall in beiden Zuleitungen 10 Ströme in dieselbe Richtung. Die erfindungsgemäße Ausführungsform mit den Spulen 38 kann dieses Problem nicht lösen, sondern lediglich abschwächen, da die Potentialdifferenzen zwischen den beiden Spulen 38 geringer ausfallen als zwischen Spulen gemäß Stand der Technik. Außerdem weisen erfindungsgemäße Spulenanordnungen A1 aufgrund der Symmetrieeigenschaften keine Kreisstromkomponente in den Zuleitungen auf. Darüber hinaus führt die Symmetrie der einzelnen Spulen 38 zu einer exakten Eliminierung der induktiven Kopplungen.

Bei ungeschickter Ausführung der Zuleitungen 10 können diese allerdings wie im Stand der Technik mittels induktiver Kopplung einen bedeutenden Anteil zur Kopplung zwischen den Spulen-/Resonatoranordnungen A1, A2 beitragen. Um zu vermeiden, dass die Zuleitungen der äußeren Spulenanordnung A1 mit dem inneren Resonator A2 koppeln, müssen diese symmetrisch zur Mittelebene 5 so weit nach außen geführt werden, dass die Verbindung der beiden Spulen 38 an einer Stelle im Raum ausgeführt wird, an der das Feld des Resonators A2 bereits sehr klein ist. Alternativ können die Zuleitungen 10 auch abgeschirmt werden.

Im Gegensatz zu Spulen gemäß Stand der Technik sind die Anschlusspunkte 12 des Netzwerkes an die Zuleitungen 10 bei den Spulen 38 potentialfrei. Daher werden keine verlustbehafteten Sperrfilter mehr benötigt. Dies vereinfacht den Bau und die Abstimmung eines MR-Messkopfes wesentlich und führt zu geringeren Verlusten bei Resonanz des Resonators A2.

In **Fig. 3d** und **3e** sind zwei Spulenanordnungen A1 dargestellt, die nicht galvanisch angeschlossen sind. Sie können z.B. induktiv angekoppelt werden. Die Spulenanordnung A1 aus Fig. 3e ist mittels zusätzlicher reaktiver Elemente auf zwei Resonanzfrequenzen abgestimmt. Diese beiden Spulenanordnungen ohne Zuleitungen lösen das Problem der Kopplung zwischen Zuleitung und innerem Resonator A2 auf elegante Art und Weise. Darüber hinaus entstehen beim Betrieb des inneren Resonators A2 nur geringfügige Verluste, da die Potentialdifferenzen zwischen den beiden Spulen der Spulenanordnung A1 nicht durch Stromfluss in Zuleitungen ausgeglichen werden können.
Die einzigen residuellen Kopplungen dieser Spulenanordnungen A1 sind elektrische Kopplungen einer Stange des inneren Resonators A2 zu einer Stange der Spule, sowie eines ringförmigen Elementes des Resonators A2 zu einem ringförmigen Element der äußeren Spule. Diese direkten Kopplungen können nicht eliminiert werden, haben allerdings keinen wesentlichen Einfluss auf den Gesamtmode, da sie sich bei sinnvollem Aufbau der Spulen/Resonatoranordnungen aufgrund der Symmetrien differenziell auslöschen.

Das Resultat des Einbaus einer im Rahmen der Erfindung ausgestalteten Spulenanordnung A1 in einen NMR-Messkopf ist es, dass die Performance der inneren Resonatoranordnung A2 nur unwesentlich durch die äußere Spulenanordnung A1 beeinflusst wird. Dies ist insbesondere dann sinnvoll, wenn der innere Resonator A2 deutlich höhere Güte aufweist als die äußere Spulenanordnung A1. Weiterhin ändert sich die Frequenz des inneren Resonators A2 nur unwesentlich, wenn eine Spule um sie herum montiert wird. Dies wird durch die vernachlässigbare Kopplung erreicht. Die verbleibende Reduktion der Güte bzw. Frequenzverschiebung der inneren Spulenanordnung A2 ist auf eine Abschirmwirkung der äußeren Spulenanordnung A1 sowie die oben erwähnten direkten Kopplungen (Stange-Stange bzw. Ring-Ring) zurückzuführen.

Bisher wurde in der Diskussion davon ausgegangen, dass die Resonanzen der äußeren Spulenanordnung A1 vernachlässigt werden können. Es wurden nur Kopplungen über Potentiale betrachtet, die antisymmetrisch zur Symmetrieebene 5 sind. In der Realität ist diese Vereinfachung allerdings nicht immer erlaubt. Die äußere Spulenanordnung A1 weist eine Vielzahl von Moden (Eigenresonanzen) auf, die auch symmetrische Potentialverteilungen haben können. Die Kopplungen mit diesen höheren Moden der äußeren Spule treten insbesondere dann auf, wenn mindestens eine Frequenz, auf die die äußere Spule abgestimmt ist, niedriger ist als die tiefste Frequenz des inneren Resonators A2.

Ähnlich wie bei Spulen gemäß Stand der Technik können diese höheren Moden den Spulen S1 und/oder S2 eines erfindungsgemäßen Probenkopfes problematisch werden. Z.B. die erste Oberschwingung einer Zweiwindungsspule gemäß Fig. 1 (Im Falle paarweiser Anordnung und induktiver Ankopplung der 4. Mode; im Falle von galvanischer Parallelschaltung der Spulen der 3. Mode, d.h. der Anti-Helmholtz-mode der ersten Oberschwingung) kann zu einer sehr starken Kopplung mit der inneren Spulen/Resonatoranordnung A2 führen, da dieser Mode ein effektives H-Feld senkrecht zum tiefsten Mode einer Spule S1, S2 erzeugt. Wird diese nun senkrecht auf eine zweite Spulen/Resonatoranordnung A2 ausgerichtet, so koppelt die innere Anordnung A2 induktiv mit der ersten Oberschwingung der Spulenanordnung A1.

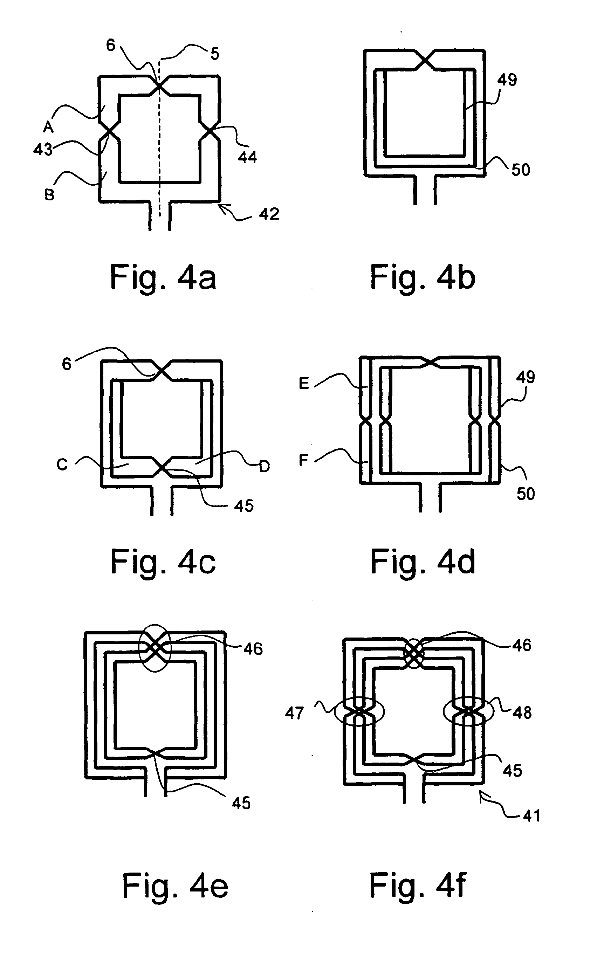

Im Gegensatz zu Spulen gemäß Stand der Technik kann diese magnetische Kopplung bei Spulen S1 und/oder S2, mit Bezugszeichen 42, reduziert werden, indem zwei (oder mehr) zusätzliche Kreuzungspunkte 43, 44 eingefügt werden **(****Fig. 4a****)**. Sinnvollerweise werden diese so angeordnet, dass die Kopplung zwischen den beiden Spulen/Resonatoranordnungen A1, A2 durch die Flächen A denen durch die Flächen B für den zu entkoppelnden Mode entgegengesetzt identisch sind. Sollen weitere Moden entkoppelt werden, so können zusätzliche Kreuzungspunkte eingefügt werden. Auf diese Art und Weise kann eine Spulenanordnung A1 nicht nur die Kopplungen zwischen den Grundmoden zweier Spulenanordnungen A1, A2 stark reduzieren, sondern auch die Kopplungen mit höheren Moden weitestgehend auslöschen.

**Fig. 4a** zeigt dazu eine Spule (S1 und/oder S2) 42 für einen erfindungsgemäßen MR-Probenkopf, die zwei serielle Windungen hat. Sie weist einen Kreuzungspunkt 6 auf der Mittelebene 5 auf, sowie zwei weitere Kreuzungspunkte 43, 44, die spiegelsymmetrisch bezüglich der Mittelebene 5 liegen. Diese weiteren Kreuzungspunkte 43, 44 bewirken, dass die Flüsse durch die Bereiche A und B entgegengesetzt mit der Oberschwingung koppeln. Dadurch wird die magnetische Kopplung aufgehoben. Die Entkopplung der Grundschwingung wird hierbei nicht beeinflusst.

Anmerkung: Die Spule S1, S2 für einen erfindungsgemäßen MR-Probenkopf beruht auf einem anderen Prinzip als die Doty Litz-Coil (US 6 060 882). Letztere verwendet Kreuzungspunkte, um bei einer Mehrwindungs-Parallel-Spule identische Ströme in allen Parallelpfaden zu erhalten. Das Prinzip ist es hierbei, die Induktivitäten der einzelnen Pfade zu egalisieren. Die elektrische Symmetrie kann bei einer Parallel-Spule ebenfalls eingehalten sein. Das Prinzip der Kreuzungen der erfindungsgemäßen Spule ist es, einerseits mittels Kreuzungspunkten (6, 23, 24) eine elektrische Symmetrie in einer Serie-Spule zu erreichen, die bei allen Seriespulentypen gemäss Stand der Technik nicht existiert, und andererseits mittels zusätzlicher Kreuzungspunkte (43, 44) induktive Kopplungen von höheren Moden zu reduzieren oder zu verhindern.

Eine Kombination aus Serie und Parallel-Spule wie z.B. in US 6 060 882 dargestellt ist auch möglich: eine oder mehrere der Seriewindungen können in zwei oder mehr Parallelpfade aufgespalten werden, wobei eventuell zusätzliche Kreuzungspunkte zwischen den Parallelpfaden eingefügt werden können wie in US 6 060 882 offenbart.

**Fig. 4b** zeigt eine Zweiwindungsspule für einen erfindungsgemäßen MR-Probenkopf, bei der die innere Windung in zwei Parallelpfade 49 und 50 aufgespalten ist.

In **Fig. 4c** ist ein zusätzlicher Kreuzungspunkt 45 auf der Symmetrieebene eingefügt, bei dem die Parallelpfade gekreuzt werden um weitestgehend identische Ströme in den Parallelpfaden zu erreichen. Hierbei sollten die Flächen C und D gleiche Größe aufweisen, was durch die Symmetrie automatisch erreicht wird. Man beachte, dass der Kreuzungspunkt 6 die Symmetrie der Spule sicherstellt, wohingegen der Kreuzungspunkt 45 die Ströme in den Parallelpfaden homogenisiert.

**Fig. 4d** zeigt eine Zweiwindungs-Seriespule, bei der die "Stangen" als zwei parallele Stangen ausgeführt wurden. Die vier zusätzlichen Kreuzungspunkte dienen dazu die Ströme in den Stangen weitestgehend identisch zu halten. Hierbei sollte der magnetische Fluss durch die Flächen E und F im Betrieb der Spule identisch sein.

In **Fig. 4e** ist eine Zweiwindungs-Seriespule dargestellt, bei der die über die volle Länge des Leiters zwei Parallelpfade existieren. Der Kreuzungspunkt 45 führt hierbei zur Homogenisierung der Ströme zwischen den Parallelwindungen, die vier Kreuzungspunkte 46 zur elektrischen Symmetrie. Insgesamt weist diese Spule bereits 5 Kreuzungspunkte auf.

Schließlich wird in **Fig. 4f** eine Zweiwindungs-Seriespule gezeigt, bei der die über die volle Länge des Leiters zwei Parallelpfade existieren und in Bezug auf die Spule aus Fig. 4e noch weitere Kreuzungsgebiete 47 und 48 eingefügt wurden, um induktive Kopplungen mit höheren Moden zu reduzieren. Diese Spule weist insgesamt 13 Kreuzungspunkte auf.

### Ausführungsformen von Spulen bzw. Spulenanordnungen:

1. Drahtspule
   Vorteil: Kreuzungspunkte durch Biegen herstellbar, keine
   Verbindungstechnik für Kreuzungspunkte notwendig.
2. Folien-/Dünnschichtspule, Kreuzungspunkte mittels Brücken (aufgelötet/geschweißt)
   Vorteil: Einfache Herstellbarkeit mittels automatisierbarer Prozesse.
3. Folienspulen aus flexiblem PCB-Material, Kreuzungspunkte mittels Verbindung durch das Dielektrikum hindurch, entweder zwischen Schichten auf beiden Seiten oder mittels Brücke wie im Fall 2.
   Vorteil: Werden doppelseitig mit Leitermaterial beschichte flexible PCBs verwendet, so kann die Spule dergestalt ausgelegt werden, dass auch im Falle mehrerer Kreuzungspunkte im Idealfall lediglich eine einzelne Durchkontaktierung notwendig wird. Hierbei kann die Durchkontaktierung von den Kreuzungspunkten losgelöst werden:

Die **Figuren 5a bis 5c** zeigen den Aufbau einer Folienspule (S1 und/oder S2) einer Spulenanordnung A1 für einen erfindungsgemäßen MR-Probenkopf. Auf einer ersten Seite der Folie ist ein erster Leiterabschnitt 51 angebracht, und auf einer zweiten Seite der Folie sind zwei weitere Leiterabschnitte 52 angebracht. In der vollständigen Spule 53, die in Fig. 5a dargestellt ist, werden die beiden Leiterabschnitte 51, 52 mittels zweier Durchkontaktierungen 54 durch die dielektrische Folie verbunden.

In Fig. 5d bis 5f ist eine Spule S1 und/oder S2 mit drei Kreuzungspunkten und zwei Durchkontaktierungen dargestellt. Diese Ausführungsform hat den Vorzug gegenüber der Spule von Fig. 5a, in z-Richtung möglichst geringe Abmessungen zu besitzen. Darüber hinaus können die Überlappungen der Spulenwindungen an den Kreuzungspunkten sowie an den Querverbindungen so ausgeführt werden, dass die hierbei gebildete Kapazität die Spule bereits auf eine Messfrequenz abstimmt. Wenn die Kapazität zwischen den Leiterabschnitten 55 und 56 am oberen Ende der Spule groß genug ist, dann kann auch vollständig auf eine Durchkontaktierung verzichtet werden.

In **Fig. 5g** ist eine Ausführungsform auf PCB-Material der Spule aus Fig. 4f gezeigt. Die Spule in Fig. 5g weist trotz dreizehn Kreuzungspunkten lediglich sechs Durchkontaktierungen auf.

In **Fig. 5h** ist eine alternative Ausführungsform der Spule aus Fig. 5a gezeigt: Die Zuleitungen werden auf unterschiedlichen Seiten des PCB-Materials angeschlossen, so dass sie mit lediglich einer einzigen Durchkontaktierung 54, die nicht an einem Kreuzungspunkt liegen muss, auskommt.

**Fig. 5i** illustriert die Stärke dieser Methode: Die Spule in Fig. 5i kommt mit lediglich zwei Durchkontaktierungen bei dreizehn Kreuzungspunkten aus. Wenn die Dicke des Dielektrikums gegenüber den Abmessung groß ist, wird die notwendige Symmetrie in den elektrischen Feldern bei Anwendung dieser Methode allerdings zu stark beeinflusst, was den möglichen Gewinn gegenüber einer Spule gemäß Stand der Technik verringern würde. In diesem Falle ist es sinnvoll, mehrere Durchkontaktierungen vorzusehen um die Symmetrie wiederherzustellen.

Es ist offensichtlich, dass alle real hergestellten Kreuzungspunkte die Symmetrie der Spule leicht verletzen. Diese leichte Asymmetrie führt jedoch nur zu einer vernachlässigbaren zusätzlichen Kopplung zwischen den zwei Spulensystemen A1, A2. Eine solche geringfügige Verletzung der Symmetrie an Kreuzungspunkten soll daher im Rahmen der Erfindung außer Betracht bleiben. Die zusätzliche Kopplung ist, wenn überhaupt existent, eher induktiver Natur und kann durch geschickte Positionierung der Brücken reduziert werden. Eine elektrische Asymmetrie ist in diesem Falle lediglich lokal vorhanden, nicht jedoch global wie im Falle der Spulen gemäß Stand der Technik. Daher führt sie zu keinen wesentlichen Kopplungen.

Eine Mehrwindungsspule im Sinne der Erfindung liegt auch vor, wenn Spannungsteiler entlang der Leiterlänge integriert sind (hierbei kann entweder eine integrierte Kapazität oder aber ein diskreter "Chip"-Kondensator verwendet werden) oder integrierte Kondensatoren zur Abstimmung der Spule als einfacher "Resonator" auf eine bestimmte Frequenz integriert sind. Ist die Spule durch integrierte Kondensatoren auf eine oder mehrere Resonanzfrequenzen abgestimmt, so sind Zuleitungen nicht mehr zwingend notwendig. Die Spule kann an Stelle einer galvanischen oder kapazitiven Kopplung über die Zuleitungen nun auch induktiv angekoppelt werden.

Mit den erfindungsgemäßen Spulenanordnungen können Kernspinresonanz-Messköpfe mit zwei oder mehr Spulen/Resonatoranordnungen A1, A2 aufgebaut werden, von denen mindestens eine eine Mehrwindungs-Seriell-Parallel-Spulenanordnung ist, zwischen denen die Kopplung sehr gering ist.

### Bezugszeichenliste

- 1.: Spule
- 2.: Spule
- 3.: Windung
- 4.: Windung
- 5.: Mittelebene
- 6.: Kreuzungspunkt
- 7.: Leiterabschnitt
- 8.: Leiterabschnitt
- 9.: Fenster
- 10.: Zuleitungen
- 11.: Anschlusspunkt der Zuleitungen
- 12.: Anschlusspunkt des Netzwerkes
- 21.: Spule
- 22.: Anschlusspunkt der Zuleitungen
- 23.: Kreuzungspunkt
- 24.: Kreuzungspunkt
- 25.: Leiterabschnitt
- 26.: Mittlere Windung
- 27.: Leiterabschnitt
- 28.: Äussere Windung
- 29.: Leiterabschnitt
- 30.: Innere Windung
- 31.: Leiterabschnitt
- 32.: Birdcage

- 33.: H-Symmetrie BC
- 34.: E-Symmetrie BC
- 35.: E-Symmetrie BC
- 36.: Spule
- 37.: Kondensator
- 38.: Spule
- 39.: Kondensator
- 41.: Spule
- 42.: Spule
- 43.: Kreuzungspunkt
- 44.: Kreuzungspunkt
- 45.: Kreuzungspunkt
- 46.: Kreuzungspunkte
- 47.: Kreuzungspunkte
- 48.: Kreuzungspunkte
- 49.: Parallelpfad
- 50.: Parallelpfad
- 51.: Leiterabschnitt
- 52.: Leiterabschnitte
- 53.: Spule
- 54.: Durchkontaktierungen
- 55.: Leiterabschnitte
- 56.: Leiterabschnitt

## Patentansprüche

1. Kernspinresonanz-Messkopf umfassend mindestens zwei Spulen/Resonatoranordnungen A1 und A2, wobei mindestens eine der Spulen/Resonatoranordnungen A1 zwei sattelförmige Spulen S1 und S2 (1, 2; 21; 41, 42; 53) umfasst, wobei die Spulen (1, 2; 21; 41, 42; 53) jeweils ein Fenster (9) aufweisen, um das N Windungen (3, 4; 26, 28, 30) liegen, die in Serie geschaltet sind, mit N größer oder gleich 2,
wobei die Spulen/Resonatoranordnungen A1 und A2 senkrecht zueinander orientiert sind,
und wobei die Spulen/Resonatoranordnungen A1 und A2 verschiedene Resonanzfrequenzen aufweisen,
**dadurch gekennzeichnet,**
**dass** die Spulen S1 und S2 (1, 2; 21; 41, 42; 53) jeweils bezüglich einer Mittelebene (5) der jeweiligen Spule (1, 2; 21; 41, 42; 53), die senkrecht auf dem Fenster (9) der jeweiligen Spule steht, spiegelsymmetrisch aufgebaut sind, wobei die Spulen S1, S2 (1, 2; 21; 41, 42; 53) jeweils wenigstens N-1 Kreuzungspunkte (6; 23, 24) zwischen Leiterabschnitten (7, 8; 25, 27, 29, 31; 51, 52; 55; 56) aufweisen, wobei diese Kreuzungspunkte (6; 23, 24) auf der Mittelebene (5) der jeweiligen Spule (1, 2; 21; 41, 42; 53) angeordnet sind,
und **dass** die Mittelebenen (5) der Spulen S1 und S2 identisch sind,
so dass die elektromagnetische Kopplung zwischen den zwei Spulen/Resonatoranordnungen A1 und A2 bei der Resonanzfrequenz von A2 minimal ist.

2. Kernspinresonanz-Messkopf nach Anspruch 1, **dadurch gekennzeichnet, dass** die Spulen S1 und/oder S2 (41, 42) jeweils 2*J weitere Kreuzungspunkte (43, 44; 47, 48) zwischen Leiterabschnitten (7, 8; 25, 27, 29, 31; 51, 52; 55; 56) aufweisen, wobei die weiteren Kreuzungspunkte (43, 44; 47, 48) paarweise symmetrisch zur jeweiligen Mittelebene (5) liegen, mit J größer oder gleich 1.

3. Kernspinresonanz-Messkopf nach einem der vorhergehenden Ansprüche, **dadurch gekennzeichnet, dass** die Spulen S1, S2 (1, 2; 21; 41, 42; 53) so aufgebaut ist, dass sich bei Betrieb der Spulen (1, 2; 21; 41, 42; 53) im Resonanzfall eine bezüglich der jeweiligen Mittelebene (5) spiegelsymmetrische, aber gegengleiche Potentialverteilung auf der jeweiligen Spule S1, S2 (1, 2; 21; 41, 42; 53) einstellt.

4. Kernspinresonanz-Messkopf nach einem der Ansprüche 1 bis 3, **dadurch gekennzeichnet, dass** die Spulen S1 und/oder S2 (1, 2; 21; 41, 42; 53) jeweils als Drahtspule ausgeführt sind.

5. Kernspinresonanz-Messkopf nach einem der Ansprüche 1 bis 3, **dadurch gekennzeichnet, dass** die Spulen S1 und/oder S2 (1, 2; 21; 41, 42; 53) jeweils als Folien- oder Dünnschichtspule ausgeführt sind.

6. Kernspinresonanz-Messkopf nach Anspruch 5, **dadurch gekennzeichnet, dass** Kreuzungspunkte (6; 23, 24) und/oder weitere Kreuzungspunkte (43, 44; 47, 48) mittels aufgelöteter oder aufgeschweißter Brücken ausgeführt sind.

7. Kernspinresonanz-Messkopf nach Anspruch 5 oder 6, **dadurch gekennzeichnet, dass** die Spulen S1 und/oder S2 (1, 2; 21; 41, 42; 53) jeweils als Folienspule aus flexiblem PCB(=printed circuit board)-Material ausgeführt sind.

8. Kernspinresonanz-Messkopf nach Anspruch 7, **dadurch gekennzeichnet, dass** die Spulen S1 und/oder S2 (1, 2; 21; 41, 42; 53) jeweils aus wenigstens N Spulenabschnitten aufgebaut sind, die auf unterschiedlichen Ebenen angeordnet sind, und dass wenigstens N-1 Durchkontaktierungen (54) durch das Dielektrikum vorgesehen sind, die jeweils zwei Spulenabschnitte miteinander elektrisch verbinden.

9. Kernspinresonanz-Messkopf nach Anspruch 8, **dadurch gekennzeichnet, dass** eine Durchkontaktierung (54) nicht an einem Kreuzungspunkt in der jeweiligen Spule S1 und/oder S2 (1, 2; 21; 41, 42; 53) angeordnet ist.

10. Kernspinresonanz-Messkopf nach einem der vorhergehenden Ansprüche, **dadurch gekennzeichnet, dass** bei der Spulen/Resonatoranordnung A1 die zwei Spulen S1, S2 (1, 2; 21; 41, 42; 53) parallel geschaltet sind.

11. Kernspinresonanz-Messkopf nach einem der vorhergehenden Ansprüche, **dadurch gekennzeichnet, dass** die zweite Spulen/Resonatoranordnung A2 wenigstens eine planare oder sattelförmige Spule S3 umfasst, wobei die Spule S3 ein Fenster aufweist, um das N Windungen liegen, die in Serie geschaltet sind, mit N größer oder gleich 2, wobei die Spule S3 bezüglich einer Mittelebene der Spule S3, die senkrecht auf dem Fenster steht, spiegelsymmetrisch aufgebaut ist.

12. Kernspinresonanz-Messkopf nach einem der vorhergehenden Ansprüche, **dadurch gekennzeichnet, dass** die Spulen/Resonatoranordnung A2 als Birdcageresonator (32) ausgeführt ist.

13. Kernspinresonanz-Messkopf gemäß einem der vorhergehenden Ansprüche, **dadurch gekennzeichnet, dass** Impedanzen an den Zuleitungen (10) der Spulen/Resonatoranordnung A1 so gewählt sind, dass sich bei Resonanzfrequenz der anderen Spulen/Resonatoranordnung A2 symmetrische Potentiale an den Zuleitungen (10) der Spulen/Resonatoranordnung A1 einstellen.

## Claims

1. NMR probe head, comprising at least two coil/resonator configurations A1 and A2, wherein at least one of the coil/resonator configurations A1 comprises two saddle-shaped coils S1 and S2 (1, 2; 21; 41, 42; 53), wherein each coil (1, 2; 21; 41, 42; 53) has a window (9) about which N windings (3, 4; 26, 28, 30) are disposed which are connected in series, wherein N ≥ 2, wherein the coil/resonator configurations A1 and A2 are aligned perpendicularly to each other, and wherein the coil/resonator configurations A1 and A2 have different resonance frequencies, **characterized in that** each coil S1 and S2 (1, 2; 21; 41, 42; 53) is formed mirror-symmetrically relative to a central plane (5) of the respective coil (1, 2; 21; 41, 42; 53), which is perpendicular to the window (9) of the respective coil, wherein each coil S1, S2 (1, 2; 21; 41, 42; 53) has at least N-1 crossing points (6; 23, 24) between conductor sections (7, 8; 25, 27, 29, 31; 51, 52; 55; 56), wherein these crossing points (6; 23, 24) are disposed on the central plane (5) of the respective coil (1, 2; 21; 41, 42; 53),
and the central planes (5) of the coils S1 and S2 are identical to minimize the electromagnetic coupling between the two coil/resonator configurations A1 and A2 at the resonance frequency of A2.

2. NMR probe head according to claim 1, **characterized in that** each coil S1 and/or S2 (41, 42) has 2*J further crossing points (43, 44; 47, 48) between conductor sections (7, 8; 25, 27, 29, 31; 51, 52; 55; 56), wherein the further crossing points (43, 44; 47, 48) are disposed in pairs symmetrically to the respective central plane (5), with J ≥ 1.

3. NMR probe head according to any one of the preceding claims, **characterized in that** the coils S1, S2 (1, 2; 21; 41, 42; 53) are formed such that, during resonant operation of the coils (1, 2; 21; 41, 42; 53), the potential on the respective coil S1, S2 (1, 2; 21; 41, 42; 53) is distributed mirror-symmetrically but equal and opposite relative to the respective central plane (5).

4. NMR probe head according to any one of the claims 1 through 3, **characterized in that** each coil S1 and/or S2 (1, 2; 21; 41, 42; 53) is designed as a wire coil.

5. NMR probe head according to any one of the claims 1 through 3, **characterized in that** each coil S1 and/or S2 (1, 2; 21; 41, 42; 53) is designed as a sheet or thin film coil.

6. NMR probe head according to claim 5, **characterized in that** the crossing points (6; 23, 24) and/or further crossing points (43, 44; 47, 48) are formed using soldered or welded bridges.

7. NMR probe head according to claim 5 or 6, **characterized in that** each coil S1 and/or S2 (1, 2; 21; 41, 42; 53) is designed as a sheet coil of flexible PCB (printed circuit board) material.

8. NMR probe head according to claim 7, **characterized in that** each coil S1 and/or S2 (1, 2; 21; 41, 42; 53) is formed from at least N coil sections which are disposed on different planes, and at least N-1 through-contacts (54) are provided through the dielectric, each electrically connecting two coil sections.

9. NMR probe head according to claim 8, **characterized in that** a through-contact (54) is not disposed on a crossing point in the respective coil S1 and/or S2 (1, 2; 21; 41, 42; 53).

10. NMR probe head according to any one of the preceding claims, **characterized in that** the two coils S1, S2 (1, 2; 21; 41, 42; 53) of the coil/resonator configuration A1 are connected in parallel.

11. NMR probe head according to any one of the preceding claims, **characterized in that** the second coil/resonator configuration A2 comprises at least one planar or saddle-shaped coil S3, wherein the coil S3 has a window about which N windings are disposed which are connected in series, wherein N≥2, wherein the coil S3 is mirror-symmetrical relative to a central plane of the coil S3 which is perpendicular to the window.

12. NMR probe head according to any one of the preceding claims, **characterized in that** the coil/resonator configuration A2 is designed as a Birdcage resonator (32).

13. NMR probe head according to any one of the preceding claims, **characterized in that** the impedances at the feed lines (10) of the coil/resonator configuration A1 are selected such that at a resonance frequency of the other coil/resonator configuration A2, symmetric potentials form at the feed lines (10) of the coil/resonator configuration A1.

## Revendications

1. Tête de mesure pour la résonance magnétique nucléaire comprenant au moins deux dispositifs à bobines/résonateur A1 et A2, au moins un des dispositifs à bobines/résonateur A1 comprenant deux bobines S1 et S2 en forme de selle (1, 2 ; 21 ; 41, 42 ; 53), les bobines (1, 2 ; 21 ; 41, 42 ; 53) présentant chaque fois une fenêtre (9) autour de laquelle sont disposées N spires (3, 4 ; 26, 28, 30) qui sont branchées en série, avec N supérieur ou égal à 2,
les dispositifs à bobines/résonateur A1 et A2 étant orientés perpendiculairement l'un par rapport à l'autre,
et les dispositifs à bobines/résonateur A1 et A2 présentant des fréquences de résonance différentes,
**caractérisé en ce**
**que** les bobines S1 et S2 (1, 2 ; 21 ; 41, 42 ; 53) sont symétriques par rapport à un plan médian (5) de la bobine respective (1, 2 ; 21 ; 41, 42 ; 53), qui est perpendiculaire à la fenêtre (9) de la bobine respective, les bobines S1, S2 (1, 2 ; 21 ; 41, 42 ; 53) présentant chaque fois au moins N-1 points de croisement (6 ; 23, 24) entre des tronçons de conducteurs (7, 8 ; 25, 27, 29, 31 ; 51, 52 ; 55 ; 56), ces points de croisement (6 ; 23, 24) étant disposés dans le plan médian (5) de la bobine respective (1, 2 ; 21 ; 41, 42 ; 53),
et **que** les plans médians (5) des bobines S1 et S2 sont identiques, de sorte que le couplage électromagnétique entre les deux dispositifs à bobines/résonateur A1 et A2 est minimal à la fréquence de résonance de A2.

2. Tête de mesure pour la résonance magnétique nucléaire selon la revendication 1, **caractérisée en ce que** les bobines S1 et/ou S2 (41, 42) présentent chaque fois 2*J autres points de croisement (43, 44 ; 47, 48) entre des tronçons de conducteurs (7, 8 ; 25, 27, 29, 31 ; 51, 52 ; 55 ; 56), les autres points de croisement (43, 44 ; 47, 48) étant disposés par paires symétriquement au plan médian (5) respectif, avec J supérieur ou égal à 1.

3. Tête de mesure pour la résonance magnétique nucléaire selon une des revendications précédentes, **caractérisée en ce que** les bobines S1, S2 (1, 2 ; 21 ; 41, 42 ; 53) sont conçues de façon qu'il s'établisse lors du fonctionnement des bobines (1, 2 ; 21 ; 41, 42 ; 53), à la résonance, une répartition de potentiel symétrique mais diamétralement opposée par rapport au plan médian respectif (5) sur la bobine S1, S2 respective (1, 2 ; 21 ; 41, 42 ; 53).

4. Tête de mesure pour la résonance magnétique nucléaire selon une des revendications 1 à 3, **caractérisée en ce que** les bobines S1 et/ou S2 (1, 2 ; 21 ; 41, 42 ; 53) sont chaque fois réalisées sous forme de bobine de fil.

5. Tête de mesure pour la résonance magnétique nucléaire selon une des revendications 1 à 3, **caractérisée en ce que** les bobines S1 et/ou S2 (1, 2 ; 21 ; 41, 42 ; 53) sont chaque fois réalisées sous forme de bobine à feuille ou de bobine à couche mince.

6. Tête de mesure pour la résonance magnétique nucléaire selon la revendication 5, **caractérisée en ce que** les points de croisement (6 ; 23, 24) et/ou les autres points de croisement (43, 44 ; 47, 48) sont réalisés au moyen de ponts brasés ou soudés.

7. Tête de mesure pour la résonance magnétique nucléaire selon la revendication 5 ou 6, **caractérisée en ce que** les bobines S1 et/ou S2 (1, 2; 21 ; 41, 42 ; 53) sont chaque fois réalisées sous forme de bobine à feuille en matériau de PCB (= printed circuit board) flexible.

8. Tête de mesure pour la résonance magnétique nucléaire selon la revendication 7, **caractérisée en ce que** les bobines S1 et/ou S2 (1, 2 ; 21 ; 41, 42 ; 53) sont chaque fois constituées d'au moins N tronçons de bobine qui sont disposés dans des plans différents, et qu'au moins N-1 traversées d'interconnexion (54) à travers le diélectrique sont prévues, qui relient chaque fois électriquement deux tronçons de bobine entre eux.

9. Tête de mesure pour la résonance magnétique nucléaire selon la revendication 8, **caractérisée en ce qu'**une traversée d'interconnexion (54) n'est pas disposée à un point de croisement dans la bobine S1 et/ou S2 respective (1, 2 ; 21 ; 41, 42 ; 53).

10. Tête de mesure pour la résonance magnétique nucléaire selon une des revendications précédentes, **caractérisée en ce que** dans le dispositif à bobines/résonateur A1, les deux bobines S1, S2 (1, 2 ; 21 ; 41, 42 ; 53) sont branchées en parallèle.

11. Tête de mesure pour la résonance magnétique nucléaire selon une des revendications précédentes, **caractérisée en ce que** le deuxième dispositif à bobines/résonateur A2 comprend au moins une bobine S3 planaire ou en forme de selle, la bobine S3 présentant une fenêtre autour de laquelle sont disposées N spires qui sont branchées en série, avec N supérieur ou égal à 2, la bobine S3 étant symétrique par rapport à un plan médian de la bobine S3 qui est perpendiculaire à la fenêtre.

12. Tête de mesure pour la résonance magnétique nucléaire selon une des revendications précédentes, **caractérisée en ce que** le dispositif à bobines/résonateur A2 est réalisé sous la forme d'un résonateur de type « cage d'oiseau » (32).

13. Tête de mesure pour la résonance magnétique nucléaire selon une des revendications précédentes, **caractérisée en ce que** les impédances des lignes d'alimentation (10) du dispositif à bobines/résonateur A1 sont choisies de façon qu'à la fréquence de résonance de l'autre dispositif à bobines/résonateur A2, il s'établisse des potentiels symétriques sur les lignes d'alimentation (10) du dispositif à bobines/résonateur A1.
